# EUROPEAN PATENT APPLICATION

(11) **EP 4 657 499 A1**
(43) Date of publication of application: **03.12.2025**
(21) Application number: 25166004.9
(22) Date of filing: 25.03.2025
(51) Int. Cl.: H01L 21/02, H01L 21/32, H01L 21/033, H01L 21/311

(54) **PROCESSING METHOD, METHOD OF MANUFACTURING SEMICONDUCTOR DEVICE, PROCESSING APPARATUS, AND PROGRAM**

(30) Priority: 30.05.2024 JP 2024087895
(71) Applicant: Kokusai Electric Corporation, Tokyo 101-0045 (JP)
(72) Inventor: TAKANO, Nozomu, Toyama-shi, Toyama, 9392393 (JP); NAKATANI, Kimihiko, Toyama-shi, Toyama, 9392393 (JP); WASEDA, Takayuki, Toyama-shi, Toyama, 9392393 (JP); HAMADA, Keitaro, Toyama-shi, Toyama, 9392393 (JP)
(74) Representative: Bardehle Pagenberg Partnerschaft mbB Patentanwälte Rechtsanwälte

(57) **Abstract**

There is provided a technique that includes: (a) providing a substrate including a first surface and a second surface whose material is different from a material of the first surface, a first oxide film being formed on the first surface, and a second oxide film being formed on the second surface; and (b) removing the second oxide film formed on the second surface while leaving the first oxide film formed on the first surface by exposing the substrate to an etching agent.

## Description

### CROSS-REFERENCE TO RELATED APPLICATION

This application is based upon and claims the benefit of priority from Japanese Patent Application No. 2024-087895, filed on May 30, 2024, the entire contents of which are incorporated herein by reference.

### TECHNICAL FIELD

The present disclosure relates to a processing method, a method of manufacturing a semiconductor device, a processing apparatus, and a program.

### BACKGROUND

In the related art, as a process of manufacturing a semiconductor device, a process of selectively growing and forming a film on a specific surface among a plurality of types of surfaces in which materials exposed on a surface of a substrate are different from each other (hereinafter, this process is also referred to as selective growth or a selective film formation) may be often carried out.

### SUMMARY

Some embodiments of the present disclosure provide a technique capable of effectively performing a selective process on a desired surface.

According to some embodiments of the present disclosure, there is provided a technique that includes: (a) providing a substrate including a first surface and a second surface whose material is different from a material of the first surface, a first oxide film being formed on the first surface, and a second oxide film being formed on the second surface; and (b) removing the second oxide film formed on the second surface while leaving the first oxide film formed on the first surface by exposing the substrate to an etching agent.

### BRIEF DESCRIPTION OF DRAWINGS

The accompanying drawings, which are incorporated in and constitute a part of the specification, illustrate embodiments of the present disclosure.
FIG. 1 is a schematic configuration view of a vertical process furnace of a processing apparatus suitably used in some embodiments of the present disclosure, in which a portion of a process furnace is shown in a vertical cross section.
FIG. 2 is a schematic configuration view of the vertical process furnace of the processing apparatus suitably used in the embodiments of the present disclosure, in which a portion of the process furnace is shown in a cross section taken along line A-A in FIG. 1.
FIG. 3 is a schematic configuration diagram of a controller of a processing apparatus suitably used in some embodiments of the present disclosure, in which a control system of the controller is shown in a block diagram.
FIG. 4A is a schematic cross-sectional view showing a surface of a wafer where a native oxide film formed on a first surface and a second surface.
FIG. 4B is a schematic cross-sectional view showing a surface of the wafer after removing the native oxide film formed on the first surface and the second surface by performing step C in a state of FIG. 4A.
FIG. 4C is a schematic cross-sectional view showing a surface of the wafer after forming a first oxide film on the first surface and a second oxide film on the second surface by performing step A in a state of FIG. 4B.
FIG. 4D is a schematic cross-sectional view showing a surface of the wafer after selectively removing the second oxide film formed on the second surface by performing step B in a state of FIG. 4C.
FIG. 4E is a schematic cross-sectional view showing a surface of the wafer after modifying a surface of the first oxide film formed on the first surface so as to form an inhibitor layer on the surface of the first oxide film by performing step D in a state of FIG. 4D.
FIG. 4F is a schematic cross-sectional view showing a surface of the wafer after forming a film on the second surface by performing step E in a state of FIG. 4E.
FIG. 5 is a graph showing measurement results of a thickness of a film formed on the first surface and a thickness of a film formed on the second surface for evaluation samples 1 and 2.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

### (1) First Embodiment

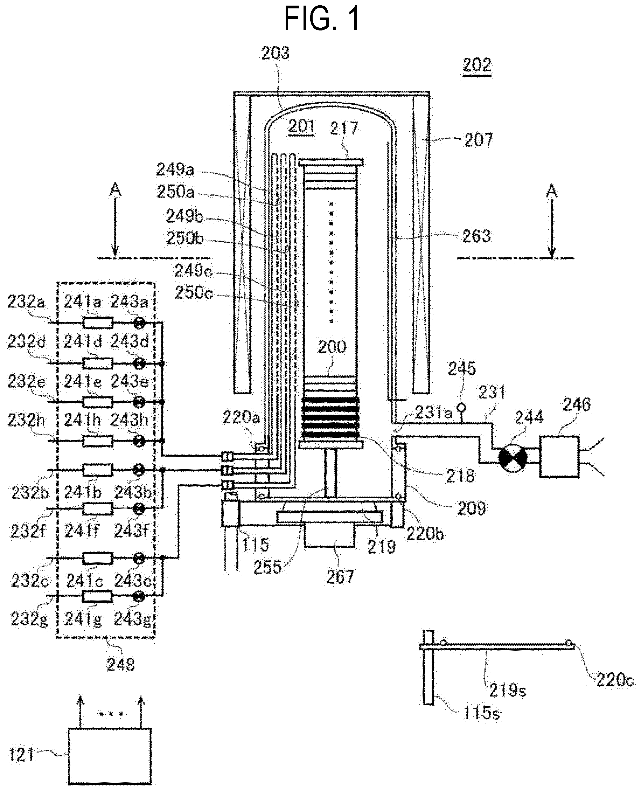

A first embodiment of the present disclosure will now be described mainly with reference to FIGS. 1 to 3 and 4A to 4F. The drawings used in the following description are schematic, and dimensional relationship, ratios, and the like of various components shown in the drawings may not match actual ones. Further, dimensional relationships, ratios, and the like of various components among plural figures may not match one another.

### (1.1) Configuration of Processing Apparatus

As shown in FIG. 1, a process furnace 202 of a processing apparatus includes a heater 207 as a temperature regulator (a heating part). The heater 207 is formed in a cylindrical shape and is supported by a support plate so as to be vertically installed. The heater 207 functions as an energy applier configured to apply energy to a gas, and also functions as an activator (an exciter) when thermally activating (exciting) the gas.

A reaction tube 203 is disposed inside the heater 207 to be concentric with the heater 207. The reaction tube 203 is made of, for example, a heat resistant material such as quartz (SiO₂) or silicon carbide (SiC), and formed in a cylindrical shape with its upper end closed and its lower end opened. A manifold 209 is disposed to be concentric with the reaction tube 203 under the reaction tube 203. The manifold 209 is made of, for example, a metal material such as stainless steel (SUS), and is formed in a cylindrical shape with both of its upper and lower ends opened. The upper end of the manifold 209 engages with the lower end of the reaction tube 203 so as to support the reaction tube 203. An O-ring 220a serving as a seal is installed between the manifold 209 and the reaction tube 203. Similar to the heater 207, the reaction tube 203 is vertically installed. A process container (reaction container) mainly includes the reaction tube 203 and the manifold 209. A process chamber 201 is formed in a hollow cylindrical area of the process container. The process chamber 201 is configured to accommodate wafers 200 as substrates. Processing on the wafers 200 is performed in the process chamber 201.

Nozzles 249a to 249c as first to third suppliers are installed in the process chamber 201 so as to penetrate a sidewall of the manifold 209. The nozzles 249a to 249c are also referred to as first to third nozzles, respectively. The nozzles 249a to 249c are made of, for example, a heat resistant material such as quartz or SiC. Gas supply pipes 232a to 232c are connected to the nozzles 249a to 249c, respectively. The nozzles 249a to 249c are different nozzles, and each of the nozzles 249a and 249c is installed adjacent to the nozzle 249b.

Mass flow controllers (MFCs) 241a to 241c, which are flow rate controllers (flow rate control parts), and valves 243a to 243c, which are opening/closing valves, are installed at the gas supply pipes 232a to 232c, respectively, sequentially from the upstream side of a gas flow. Each of gas supply pipes 232d, 232e, and 232h is connected to the gas supply pipe 232a at the downstream side of the valves 243a. Gas supply pipes 232f and 232g are connected to the gas supply pipes 232b and 232c at the downstream side of the valves 243b and 243c, respectively. MFCs 241d to 241h and valves 243d to 243h are installed at the gas supply pipes 232d to 232h, respectively, sequentially from the upstream side of a gas flow. The gas supply pipes 232a to 232h are made of, for example, a metal material such as SUS.

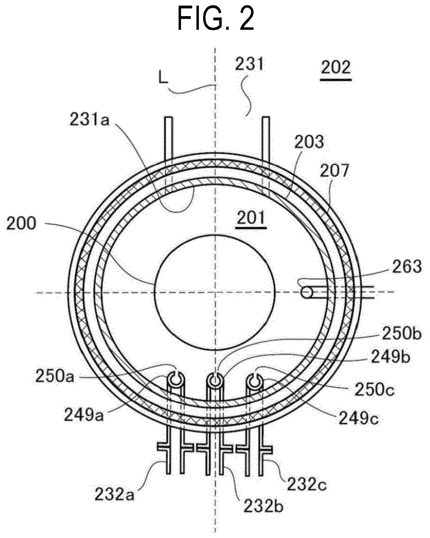

As shown in FIG. 2, each of the nozzles 249a to 249c is installed in an annular space (in a plane view) between an inner wall of the reaction tube 203 and the wafers 200 so as to extend upward from a lower side to an upper side of the inner wall of the reaction tube 203, that is, along an arrangement direction of the wafers 200. Specifically, each of the nozzles 249a to 249c is installed in a region horizontally surrounding a wafer arrangement region in which the wafers 200 are arranged at a lateral side of the wafer arrangement region, along the wafer arrangement region. In the plane view, the nozzle 249b is disposed so as to face an exhaust port 231a to be described later on a straight line with centers of the wafers 200 loaded into the process chamber 201, which are interposed therebetween. The nozzles 249a and 249c are arranged so as to sandwich a straight line L passing through the nozzle 249b and the center of the exhaust port 231a from both sides along the inner wall of the reaction tube 203 (the outer peripheries of the wafers 200). The straight line L is also a straight line passing through the nozzle 249b and the centers of the wafers 200. That is, it may be said that the nozzle 249c is installed on the side opposite to the nozzle 249a with the straight line L interposed therebetween. The nozzles 249a and 249c are arranged in line symmetry with the straight line L as the axis of symmetry. Gas supply holes 250a to 250c configured to supply a gas are formed on the side surfaces of the nozzles 249a to 249c, respectively. Each of the gas supply holes 250a to 250c is opened so as to oppose (face) the exhaust port 231a in the plane view, which enables a gas to be supplied toward the wafers 200. A plurality of gas supply holes 250a to 250c are formed from the lower side to the upper side of the reaction tube 203.

A precursor is supplied from the gas supply pipe 232a into the process chamber 201 via the MFC 241a, the valve 243a, and the nozzle 249a. The precursor is used as a film-forming agent.

A reactant is supplied from the gas supply pipe 232b into the process chamber 201 via the MFC 241b, the valve 243b, and the nozzle 249b. The reactant is used as a film-forming agent.

An oxidizing agent is supplied from the gas supply pipe 232c into the process chamber 201 via the MFC 241c, the valve 243c, and the nozzle 249c.

A modifying agent is supplied from the gas supply pipe 232d into the process chamber 201 via the MFC 241d, the valve 243d, the gas supply pipe 232a, and the nozzle 249a.

An etching agent is supplied from the gas supply pipe 232h into the process chamber 201 via the MFC 241h, the valve 243h, the gas supply pipe 232a, and the nozzle 249a.

An inert gas is supplied from the gas supply pipes 232e to 232g into the process chamber 201 via the MFCs 241e to 241g, the valves 243e to 243g, the gas supply pipes 232a to 232c, and the nozzles 249a to 249c, respectively. The inert gas acts as a purge gas, a carrier gas, a dilution gas, or the like.

A precursor supply system (precursor exposure system) mainly includes the gas supply pipe 232a, the MFC 241a, and the valve 243a. A reactant supply system (reactant exposure system) mainly includes the gas supply pipe 232b, the MFC 241b, and the valve 243b. An oxidizing agent supply system (oxidizing agent exposure system) mainly includes the gas supply pipe 232c, the MFC 241c, and the valve 243c. The precursor supply system and the reactant supply system are also referred to as a film-forming agent supply system (film-forming agent exposure system). A modifying agent supply system (modifying agent exposure system) mainly includes the gas supply pipe 232d, the MFC 241d, and the valve 243d. An etching agent supply system (etching agent exposure system) mainly includes the gas supply pipe 232h, the MFC 241h, and the valve 243h. An inert gas supply system mainly includes the gas supply pipes 232e to 232g, the MFCs 241e to 241g, and the valves 243e to 243g.

One or the entirety of the above-described various supply systems may be constituted as an integrated-type supply system 248 in which the valves 243a to 243h, the MFCs 241a to 241h, and so on are integrated. The integrated-type supply system 248 is connected to each of the gas supply pipes 232a to 232h. In addition, the integrated-type supply system 248 is configured such that operations of supplying various materials (various gases) into the gas supply pipes 232a to 232h (that is, opening/closing operations of the valves 243a to 243h, flow rate regulation operations by the MFCs 241a to 241h, and the like) are controlled by a controller 121 which will be described later. The integrated-type supply system 248 is constituted as an integral-type or detachable-type integrated unit, and may be attached to or detached from the gas supply pipes 232a to 232h and the like on an integrated unit basis, such that maintenance, replacement, extension, etc. of the integrated-type supply system 248 may be performed on an integrated unit basis.

The exhaust port 231a configured to exhaust an internal atmosphere of the process chamber 201 is installed below the sidewall of the reaction tube 203. As shown in FIG. 2, in the plane view, the exhaust port 231a is installed at a position opposing (facing) the nozzles 249a to 249c (the gas supply holes 250a to 250c) with the wafers 200 interposed therebetween. The exhaust port 231a may be installed from the lower side to the upper side of the sidewall of the reaction tube 203, that is, along the wafer arrangement region. An exhaust pipe 231 is connected to the exhaust port 231a. A vacuum pump 246 as a vacuum exhauster, is connected to the exhaust pipe 231 via a pressure sensor 245, which is a pressure detector (pressure detection part) configured to detect an internal pressure of the process chamber 201, and an auto pressure controller (APC) valve 244, which is a pressure regulator (pressure regulation part). The APC valve 244 is configured to be capable of performing or stopping a vacuum exhausting operation in the process chamber 201 by opening or closing the valve while the vacuum pump 246 is actuated, and is also configured to be capable of regulating the internal pressure of the process chamber 201 by adjusting a degree of valve opening based on pressure information detected by the pressure sensor 245 while the vacuum pump 246 is actuated. An exhaust system mainly includes the exhaust pipe 231, the APC valve 244, and the pressure sensor 245. The exhaust system may include the vacuum pump 246.

A seal cap 219, which serves as a furnace opening lid configured to be capable of hermetically sealing a lower end opening of the manifold 209, is installed under the manifold 209. The seal cap 219 is made of, for example, a metal material such as SUS, and is formed in a disc shape. An O-ring 220b, which is a seal making contact with the lower end of the manifold 209, is installed on an upper surface of the seal cap 219. A rotator 267 configured to rotate a boat 217, which will be described later, is installed under the seal cap 219. A rotary shaft 255 of the rotator 267 is connected to the boat 217 through the seal cap 219. The rotator 267 is configured to rotate the wafers 200 by rotating the boat 217. The seal cap 219 is configured to be vertically moved up or down by a boat elevator 115 which is an elevator installed outside the reaction tube 203. The boat elevator 115 is constituted as a transfer apparatus (transfer mechanism) configured to loads or unload (transfer) the wafers 200 into or out of the process chamber 201 by moving the seal cap 219 up or down.

A shutter 219s, which serves as a furnace opening lid configured to be capable of hermetically sealing a lower end opening of the manifold 209 in a state where the seal cap 219 is lowered and the boat 217 is unloaded from the process chamber 201, is installed under the manifold 209. The shutter 219s is made of, for example, a metal material such as SUS, and is formed in a disc shape. An O-ring 220c, which is a seal making contact with the lower end of the manifold 209, is installed on an upper surface of the shutter 219s. The opening/closing operation (such as elevation operation, rotation operation, or the like) of the shutter 219s is controlled by a shutter opening/closing mechanism 115s.

The boat 217 serving as a substrate support is configured to support a plurality of wafers 200, for example, 25 to 200 wafers, in such a state that the wafers 200 are arranged in a horizontal posture and in multiple stages along a vertical direction with the centers of the wafers 200 aligned with one another. That is, the boat 217 is configured to arrange the wafers 200 to be spaced apart from each other. The boat 217 is made of, for example, a heat resistant material such as quartz or SiC. Heat insulating plates 218 made of, for example, a heat resistant material such as quartz or SiC are installed in multiple stages at a lower side of the boat 217.

A temperature sensor 263 serving as a temperature detector is installed in the reaction tube 203. Based on temperature information detected by the temperature sensor 263, a state of supplying electric power to the heater 207 is regulated such that a temperature distribution in the process chamber 201 becomes a desired temperature distribution. The temperature sensor 263 is installed along the inner wall of the reaction tube 203.

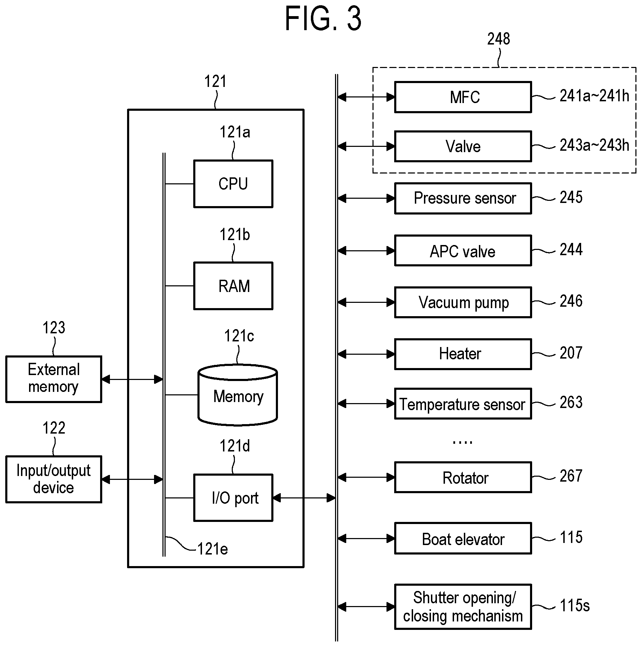

As shown in FIG. 3, a controller 121, which is a control part (control means or unit), is constituted as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus 121e. An input/output device 122 constituted as, e.g., a touch panel or the like, is connected to the controller 121. Further, an external memory 123 may be connected to the controller 121. Further, the processing apparatus may be configured to include one controller, or may be configured to include a plurality of controllers. That is, control to perform a processing sequence to be described later may be performed by using one controller, or may be performed by using a plurality of controllers. Further, the plurality of controllers may be constituted as a control system in which the plurality of controllers are connected to each other via a wired or wireless communication network, and the entire control system may perform control to perform the processing sequence to be described later. When the term "controller" is used in the present disclosure, it may include a plurality of controllers or a control system constituted by a plurality of controllers, as well as one controller.

The memory 121c is constituted by, for example, a flash memory, a hard disk drive (HDD), a solid state drive (SSD), or the like. A control program to control operations of a processing apparatus, a process recipe in which sequences and conditions of processing to be described later are written, etc. are readably recorded and stored in the memory 121c. The process recipe functions as a program that is combined to cause, by the controller 121, the processing apparatus (processing system) to execute each sequence in the processing, which will be described later, to obtain an expected result. Hereinafter, the process recipe and the control program may be generally and simply referred to as a "program (program product)." Further, the process recipe may be simply referred to as a "recipe." When the term "program" is used herein, it may indicate a case of including the recipe, a case of including the control program, or a case of including both the recipe and the control program. The RAM 121b is configured as a memory area (work area) in which programs or data read by the CPU 121a are temporarily stored.

The I/O port 121d is connected to the MFCs 241a to 241h, the valves 243a to 243h, the pressure sensor 245, the APC valve 244, the vacuum pump 246, the temperature sensor 263, the heater 207, the rotator 267, the boat elevator 115, the shutter opening/closing mechanism 115s, and so on.

The CPU 121a is configured to be capable of reading and executing the control program from the memory 121c. The CPU 121a is also configured to be capable of reading the recipe from the memory 121c according to an input of an operation command from the input/output device 122. The CPU 121a is configured to be capable of controlling the flow rate regulating operation of various kinds of materials (gases) by the MFCs 241a to 241h, the opening/closing operation of the valves 243a to 243h, the opening/closing operation of the APC valve 244, the pressure regulating operation performed by the APC valve 244 based on the pressure sensor 245, the actuating and stopping operation of the vacuum pump 246, the temperature regulating operation performed by the heater 207 based on the temperature sensor 263, the operation of rotating the boat 217 and adjusting the rotation speed of the boat 217 with the rotator 267, the operation of moving the boat 217 up or down by the boat elevator 115, the opening/closing operation of the shutter 219s by the shutter opening/closing mechanism 115s, and so on, according to contents of the read recipe.

The controller 121 may be configured by installing, on the computer, the aforementioned program recorded and stored in the external memory 123. Examples of the external memory 123 may include a magnetic disk such as a HDD, an optical disc such as a CD, a semiconductor memory such as a USB memory or a SSD, and the like. The memory 121c or the external memory 123 is constituted as a computer-readable recording medium. Hereinafter, the memory 121c and the external memory 123 may be generally and simply referred to as a "recording medium." When the term "recording medium" is used herein, it may indicate a case of including the memory 121c, a case of including the external memory 123, or a case of including both the memory 121c and the external memory 123. Further, the program may be provided to the computer by using communication means or unit such as the Internet or a dedicated line, instead of using the external memory 123.

### (1.2) Processing Process

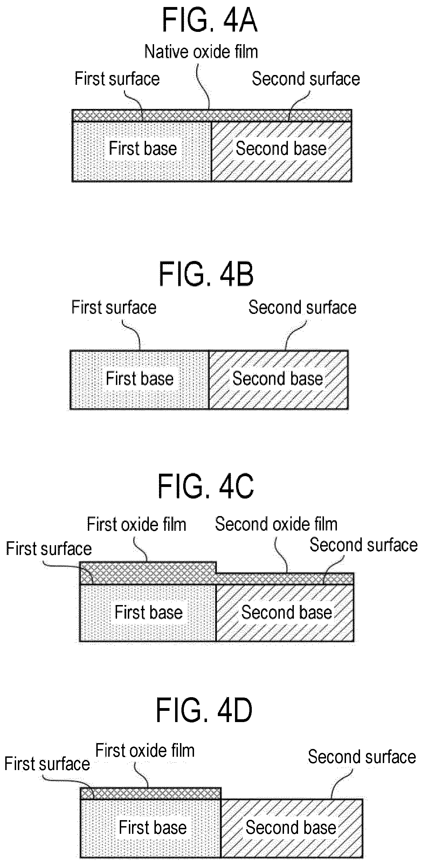

As a process (method) of manufacturing a semiconductor device by using the above-described processing apparatus, an example of a method of processing a substrate, that is, a processing sequence to selectively form a film on a second surface of a wafer 200 as a substrate among a first surface and the second surface of the wafer 200, will be described mainly with reference to FIGS. 4A to 4F. In the first embodiment, a case where the first surface (first base) includes a silicon film (Si film) and the second surface (second base) includes a silicon nitride film (SiN film) will be described. That is, in the first embodiment, an example will be described where the first surface contains silicon (Si) as a semiconductor element and the second surface contains silicon (Si) and nitrogen (N) as semiconductor elements. In the following description, operations of the respective components constituting the processing apparatus are controlled by the controller 121. The processing apparatus is also be referred to as a substrate processing apparatus, a film formation processing apparatus, or a film formation apparatus. The processing method is also be referred to as a substrate processing method, a film formation processing method, or a film formation method.

As shown in FIG. 4A, the wafer 200 includes the first base and the second base on its surface. A native oxide film is formed on the first surface of the first base and the second surface of the second base.

A processing sequence of the first embodiment includes:
(a) step A of providing a wafer 200 including a first surface and a second surface whose material is different from a material of the first surface, a first oxide film being formed on the first surface, and a second oxide film being formed on the second surface; and
(b) step B of removing the second oxide film formed on the second surface while leaving the first oxide film formed on the first surface by exposing the wafer 200 to an etching agent.

The processing sequence of the first embodiment further includes:
(c) step C of removing a native oxide film formed on the first surface and the second surface by exposing the wafer 200 before performing step A to an etching agent;
(d) step D of modifying the surface of the first oxide film on the first surface by exposing the wafer 200 after performing step B to a modifying agent so as to form an inhibitor layer on the surface of the first oxide film; and
(e) step E of forming a film on the second surface by exposing the wafer 200 after performing step D to a film-forming agent.

When the term "wafer" is used in the present disclosure, it may refer to "a wafer itself" or "a stacked body of a wafer and certain layers or films formed on a surface of the wafer." When the phrase "a surface of a wafer" is used in the present disclosure, it may refer to "a surface of a wafer itself" or "a surface of a certain layer formed on a wafer." When an expression "a certain layer is formed on a wafer" is used in the present disclosure, it may mean that "a certain layer is formed directly on a surface of a wafer itself" or that "a certain layer is formed on a layer formed on a wafer." When the term "substrate" is used in the present disclosure, it may be synonymous with the term "wafer."

The term "film" used in the present disclosure includes at least one selected from the group of a continuous layer and a discontinuous layer. For example, each of a native oxide film, a first oxide film, a second oxide film, an inhibitor layer, and a film may include a continuous layer, a discontinuous layer, or both of them.

The term "agent" used in the present disclosure includes at least one selected from the group of a gaseous substance and a liquefied substance. The liquefied substance includes a misty substance. That is, each of a precursor, a reactant, an oxidizing agent, a modifying agent, and an etching agent may include a gaseous substance, a liquefied substance such as a misty substance, or both of them.

The term "inhibitor" used in the present disclosure may refer to, in addition to a film formation inhibition effect (adsorption inhibition effect or reaction inhibition effect), a modifying agent, or residues derived from a modifying agent, for example, at least a portion of a molecular structure of a molecule constituting the modifying agent, and may also be used as a collective term for the entirety of these.

### (Wafer Charging and Boat Loading)

After the boat 217 is charged with a plurality of wafers 200 (wafer charging), the shutter 219s is moved by the shutter opening/closing mechanism 115s and the lower end opening of the manifold 209 is opened (shutter opening). Thereafter, as shown in FIG. 1, the boat 217 supporting the plurality of wafers 200 is lifted up by the boat elevator 115 to be loaded into the process chamber 201 (boat loading). In this state, the seal cap 219 seals the lower end of the manifold 209 via the O-ring 220b. Thus, the wafers 200 are provided inside the process chamber 201.

### (Pressure Regulation and Temperature Regulation)

After the boat loading is completed, an inside of the process chamber 201, that is, a space where the wafers 200 are placed, is vacuum-exhausted (decompression-exhausted) by the vacuum pump 246 to reach a desired pressure (degree of vacuum). In this operation, the internal pressure of the process chamber 201 is measured by the pressure sensor 245, and the APC valve 244 is feedback-controlled based on the measured pressure information. Further, the wafers 200 in the process chamber 201 are heated by the heater 207 so as to reach a desired processing temperature. In this operation, a state of supplying electric power to the heater 207 is feedback-controlled based on the temperature information detected by the temperature sensor 263 such that a temperature distribution in the process chamber 201 becomes a desired temperature distribution. Further, the rotation of the wafers 200 by the rotator 267 is started. The exhaust of the inside of the process chamber 201 and the heating and rotation of the wafers 200 are continuously performed at least until the processing on the wafers 200 is completed.

### (1.2.1) Step C

After that, step C is performed. In step C, the wafer 200 before performing step A is exposed to an etching agent to remove a native oxide film formed on a first surface and a second surface.

Specifically, the valve 243h is opened to allow the etching agent to flow through the gas supply pipe 232h. A flow rate of the etching agent is regulated by the MFC 241h, and the etching agent is supplied into the process chamber 201 via the gas supply pipe 232a and the nozzle 249a and is exhausted via the exhaust port 231a. In this operation, the etching agent is supplied to the wafer 200 from the side of the wafer 200, such that the wafer 200 is exposed to the etching agent. At this time, the valves 243e to 243g may be opened to allow an inert gas to be supplied into the process chamber 201 via the nozzles 249a to 249c, respectively.

By performing step C, as shown in FIG. 4B, the native oxide film formed on the first surface and the second surface may be removed to expose the first surface and the second surface. As a result, in step A, uniform processing on the first surface is possible, and uniform processing on the second surface is also possible.

As the etching agent, a substance containing fluorine (F), i.e., a fluorine-based substance, for example, a fluorine-containing gas, may be used. As the fluorine-containing gas, a fluorine-containing gas, a hydrogen- and fluorine-containing gas, a chlorine- and fluorine-containing gas, a nitrogen- and fluorine-containing gas, and a fluorine-, nitrogen-, and oxygen-containing gas, etc., for example, a fluorine (F₂) gas, a hydrogen fluoride (HF) gas, a chlorine trifluoride (ClF₃) gas, a chlorine fluoride (ClF) gas, a nitrogen fluoride (NF₃) gas, a nitrosyl fluoride (FNO) gas, etc. may be used. Like these, the etching agent may be, for example, a fluorine-containing substance, a hydrogen- and fluorine-containing substance, a chlorine- and fluorine-containing substance, a nitrogen- and fluorine-containing substance, a fluorine-, nitrogen-, and oxygen-containing substance, etc. That is, the etching agent may be, for example, a halogen alone, a hydrogen halide, an interhalogen compound, a nitrogen halide, a nitrosyl halide, etc. The etching agent may be, for example, a fluorine-based substance such as a hydrogen fluoride (HF) aqueous solution. One or more of these may be used as the etching agent.

The inert gas may be, for example, a nitrogen (N₂) gas or a rare gas. The rare gas may be, for example, an argon (Ar) gas, a helium (He) gas, a neon (Ne) gas, a xenon (Xe) gas, etc. One or more of these may be used as the inert gas. The same applies to each step to be described later.

Process conditions when using the fluorine-containing gas as the etching agent in step C are exemplified as follows:
Processing temperature: room temperature (25 degrees C) to 400 degrees C, specifically 50 to 250 degrees C
Processing pressure: 1 to 13,332 Pa, specifically 1 to 1,333 Pa
Processing time: 1 second to 120 minutes, specifically 1 minute to 60 minutes
Supply flow rate of etching agent: 0.001 to 2 slm.
Supply flow rate of inert gas (for each gas supply pipe): 0 to 20 slm

In the present disclosure, notation of a numerical range such as "25 to 400 degrees C" means that a lower limit value and an upper limit value are included in the range. Therefore, for example, "25 to 400 degrees C" means "25 degrees C or higher and 400 degrees C or lower." The same applies to other numerical ranges. In the present disclosure, a processing temperature means a temperature of the wafer 200 or an internal temperature of the process chamber 201, and a processing pressure means an internal pressure of the process chamber 201. Further, the processing time means a time during which a process is continued. Further, when 0 slm (sccm) is included in a supply flow rate, it means a case where no gas is supplied. The same applies to the following description.

Process conditions when using the HF aqueous solution as the etching agent in step C are exemplified as follows:
Processing temperature: 10 to 60 degrees C, specifically 15 to 40 degrees C
Processing time: 1 to 600 seconds, specifically 1 to 300 seconds
Concentration of etching agent: 0.1 to 5%, specifically 0.5 to 2 %.

After removing the native oxide film formed on the first surface and the second surface, the valve 243h is closed to stop the supply of the etching agent into the process chamber 201. Then, the inside of the process chamber 201 is vacuum-exhausted to remove a gaseous substance and the like remaining in the process chamber 201 from the process chamber 201. At this time, the valves 243e to 243g are opened to allow an inert gas to be supplied into the process chamber 201 via the nozzles 249a to 249c, respectively. The inert gas supplied from the nozzles 249a to 249c acts as a purge gas, whereby the inside of the process chamber 201 is purged (purging).

Further, in a case where the native oxide film formed on the first surface and the second surface of the wafer 200 is removed in advance and the wafer 200 maintained in such a state is used, step C may be omitted. In that case, step A, which will be described below, is performed after pressure regulation and temperature regulation.

### (1.2.2) Step A

In step A, a wafer 200 including a first surface and a second surface with a first oxide film formed on the first surface and a second oxide film formed on the second surface is provided.

In the first embodiment, the first oxide film and the second oxide film are formed by exposing the wafer 200 to an oxidizing agent to oxidize the first surface and the second surface. The oxidation of the first surface and the second surface is performed under a condition in which a thickness of the first oxide film formed on the first surface is greater than a thickness of the second oxide film formed on the second surface.

In detail, the wafer 200 after performing step C is exposed to the oxidizing agent. As a result, as shown in FIG. 4C, the wafer 200 with the first oxide film formed on the first surface and the second oxide film formed on the second surface is provided.

Specifically, the valve 243c is opened to allow the oxidizing agent to flow through the gas supply pipe 232c. A flow rate of the oxidizing agent is regulated by the MFC 241c, and the oxidizing agent is supplied into the process chamber 201 via the gas supply pipe 232c and the nozzle 249c and is exhausted through the exhaust port 231a. In this operation, the oxidizing agent is supplied to the wafer 200 from the side of the wafer 200, such that the wafer 200 is exposed to the oxidizing agent. At this time, the valves 243e to 243g may be opened to allow an inert gas to be supplied into the process chamber 201 via the nozzles 249a to 249c, respectively.

Process conditions when supplying the oxidizing agent in step A are exemplified as follows:
Processing temperature: 200 to 800 degrees C, specifically 300 to 600 degrees C
Processing pressure: 1 to 105,000 Pa, specifically 1,000 to 105,000 Pa
Processing time: 1 to 11,000 seconds, specifically 5 to 7,200 seconds
Supply flow rate of oxidizing agent: 0.01 to 10 slm, specifically 0.1 to 5 slm
Supply flow rate of inert gas (for each gas supply pipe): 0 to 20 slm.

In a case where the processing temperature exceeds 800 degrees C, the second oxide film formed on the second surface may become excessively thick, making it difficult to subsequently remove the second oxide film with an etching agent. In addition, when the second oxide film is removed by the etching agent, an etching under a stronger condition may be used, which may cause concern about etching damage. In addition, since the first surface and the second surface are directly oxidized at a high temperature, there may be concern about damage to each surface. By setting the processing temperature at 800 degrees C or lower, it is possible to solve these issues. By setting the processing temperature at 600 degrees C or lower, it is possible to effectively solve these issues.

In a case where the processing temperature is below 200 degrees C, the oxidation of the first surface becomes insufficient, and the first oxide film formed on the first surface becomes excessively thin, such that an inhibitor layer may not be properly formed on the surface of the first oxide film. In addition, the first oxide film may not function sufficiently as a protective film for the first surface, and the first surface may be damaged, particularly in a case where a fluorine-containing substance is used to form the inhibitor layer. By setting the processing temperature at 200 degrees C or higher, it is possible to solve these issues. By setting the processing temperature at 300 degrees C or higher, it is possible to effectively solve these issues.

For these reasons, in step A, specifically, the processing temperature may be 200 degrees C or higher and 800 degrees C or lower, and more preferably 200 degrees C or higher and 600 degrees C or lower.

Examples of the oxidizing agent may include an oxygen-containing gas, an oxygen- and hydrogen-containing gas, an oxygen- and deuterium-containing gas, an oxygen- and nitrogen-containing gas, an oxygen- and carbon-containing gas, etc. for example, an oxygen (O₂) gas, an ozone (O₃) gas, O₂ gas + hydrogen (H₂) gas, O₂ gas + deuterium (D₂) gas, O₃ gas + H₂ gas, O₃ gas + D₂ gas, a hydrogen peroxide (H₂O₂) gas, a water vapor (H₂O gas), a nitrous oxide (N₂O) gas, a nitric oxide (NO) gas, a nitrogen dioxide (NO₂) gas, a carbon dioxide (CO₂) gas, a carbon monoxide (CO) gas, etc. One or more of these may be used as the oxidizing agent. Herein, description of two gases such as "O₂ gas + H₂ gas" together means a mixture gas of O₂ gas and H₂ gas. When supplying the mixture gas, the two gases may be mixed (pre-mixed) in a supply pipe and then supplied into the process chamber 201, or the two gases may be supplied separately from different supply pipes into the process chamber 201 and then mixed (post-mixed) in the process chamber 201.

In the first embodiment, the wafer 200 is exposed to the oxidizing agent under a condition in which both the first surface and the second surface are oxidized, that is, under a condition in which non-selective oxidation is performed. Therefore, restrictions on the process conditions in step A of the first embodiment may be alleviated as compared to a case where the wafer 200 is exposed to the oxidizing agent under a condition in which the first surface is oxidized without oxidizing the second surface, that is, under a condition in which selective oxidation is performed, such that a degree of freedom of the process conditions may be increased.

A thickness of the first oxide film formed in this manner is greater than a thickness of the second oxide film. The thickness of the first oxide film is, for example, about 1 to 20 Å, and the thickness of the second oxide film is, for example, about 1 to 15 Å.

In the first embodiment, the first oxide film contains a semiconductor element and a composition of the first oxide film is richer in a semiconductor element than a stoichiometric composition. For example, a silicon oxide film of the stoichiometric composition may be expressed as SiO₂. In comparison to this, when the semiconductor element contained in the first surface is Si, a silicon oxide film with a composition which is richer in the semiconductor element than the stoichiometric composition may be expressed as, for example, SiO_{1.9}, SiO_{1.8}, SiO_{1.7}, etc. In the first embodiment, for example, the first oxide film contains Si as the semiconductor element and includes a silicon oxide film (e.g., SiO_{1.9}, SiO_{1.8}, SiO_{1.7}, etc.) with a composition which is richer in the semiconductor element (Si-richer) than a stoichiometric composition of a silicon oxide film (SiO₂).

In addition, in the first embodiment, the first oxide film and the second oxide film contain semiconductor elements, and the composition of the first oxide film is richer in the semiconductor element than the composition of the second oxide film. An expression "a composition of the first oxide film is richer in the semiconductor element than the composition of the second oxide film" means that an atomic ratio of a semiconductor element among elements constituting the first oxide film is greater than an atomic ratio of a semiconductor element among elements constituting the second oxide film. For example, when the semiconductor element is Si, a composition of an oxide film expressed by SiO_{1.7} is richer in the semiconductor element (Si-richer) than a composition of an oxide film expressed by SiO_{1.9}. In the first embodiment, it is considered that the composition of the first oxide film is richer in the semiconductor element than the composition of the second oxide film, because the first oxide film is formed by oxidizing the first surface containing Si and the second oxide film is formed by oxidizing the second surface containing Si and N. Further, it is considered that when the first surface containing Si is oxidized, a semiconductor element-rich first oxide film is formed, and when the second surface containing Si and N is oxidized, a second oxide film whose composition on a surface side is SiO₂ and whose composition on a bottom side is SiON is formed.

After the first surface and the second surface are oxidized, the valve 243c is closed to stop the supply of the oxidizing agent into the process chamber 201. Then, a gaseous substance and the like remaining in the process chamber 201 are removed from the inside of the process chamber 201 according to the same processing procedures as the purging in step C.

### (1.2.3) Step B

Then, step B is performed. In step B, the wafer 200 is exposed to an etching agent to remove the second oxide film formed on the second surface while leaving the first oxide film formed on the first surface.

By performing step B, the second surface may be exposed while leaving the first oxide film formed on the first surface, as shown in FIG. 4D. At this time, adsorption sites on the surface of the first oxide film may be adjusted and optimized by a secondary action of the etching agent. Therefore, in step D, adsorption of an inhibitor molecule on the surface of the first oxide film may be promoted, and selective formation of an inhibitor layer on the surface of the first oxide film may be effectively performed. As a result, in the film formation in step E, a film formation inhibition effect on the first surface may be enhanced, and selective formation of a film on the second surface may be effectively performed. Further, in step B, a removal accuracy of the second oxide film may be improved, and smoothness of the second surface may be improved.

As the etching agent, an etching agent which is the same as that used in step C may be used, and an etching process at this time may be performed according to the same processing procedures as the etching process in step C.

Process conditions when using the fluorine-containing gas as the etching agent in step B are exemplified as follows:
Processing temperature: room temperature (25 degrees C) to 400 degrees C, specifically 50 to 250 degrees C
Processing pressure: 1 to 13,332 Pa, specifically 1 to 1,333 Pa
Processing time: 1 second to 120 minutes, specifically 1 minute to 60 minutes
Supply flow rate of etching agent: 0.001 to 2 slm
Supply flow rate of inert gas (for each gas supply pipe): 0 to 50 slm.

Process conditions when using the HF aqueous solution as the etching agent in step B are exemplified as follows:
Processing temperature: 10 to 60 degrees C, specifically 15 to 40 degrees C
Processing time: 1 to 600 seconds, specifically 1 to 300 seconds.
Concentration of etching agent: 0.01 to 1%, specifically 0.05 to 0.5%

An exposure time of the wafer 200 to the etching agent in step B may be made to be different from an exposure time of the wafer 200 to the etching agent in step C. This makes it possible to improve a controllability of each of the process by using the etching agent in step B and the process by using the etching agent in step C. In a case where the etching agent used in step B includes a HF aqueous solution, i.e., in a case where the etching agent used in step B contains HF and H₂O, it becomes possible to more effectively adjust and optimize the adsorption sites on the surface of the first oxide film formed on the first surface by the secondary action of the etching agent when removing the second oxide film formed on the second surface by etching.

The etching agent used in step B and the etching agent used in step C contain the same substance X, and a concentration of substance X in the etching agent used in step B may be made to be different from a concentration of substance X in the etching agent used in step C. This makes it possible to improve the controllability of each of the process by using the etching agent in step B and the process by using the etching agent in step C. For example, by making the concentration of the substance X in the etching agent used in step B be lower than the concentration of the substance X in the etching agent used in step C, it becomes possible to remove the second oxide film while effectively leaving the first oxide film in step B, and also to effectively remove the native oxide film in step C. In this case, by making the exposure time of the wafer 200 to the etching agent in step B be longer than the exposure time of the wafer 200 to the etching agent in step C, it becomes possible to effectively remove the second oxide film in step B while maintaining these effects. In these cases, the substance X may contain HF. For example, the etching agent used in step B may include a HF aqueous solution or a HF gas, and the etching agent used in step C may include a HF aqueous solution or a HF gas. Further, the etching agent used in step B may include a HF aqueous solution, that is, contain HF and H₂O.

Herein, an etching rate of the first oxide film is lower than an etching rate of the second oxide film. It is considered that this is because the composition of the first oxide film is richer in the semiconductor element than the composition of the second oxide film. In detail, the first oxide film formed by oxidizing the first surface containing Si tends to be rich in the semiconductor element, i.e., Si-rich. When the first oxide film becomes Si-rich, the etching resistance becomes high and the first oxide film becomes difficult to etch. That is, the etching rate becomes low. In contrast, the second oxide film formed by oxidizing the second surface containing Si and N tends to contain SiO₂ of the stoichiometric composition at least on the surface. In a case where the second oxide film contains SiO₂ at least on the surface, the second oxide film is etched at a general etching rate. That is, in a case where both the first oxide film and the second oxide film are exposed to an etching agent simultaneously under the same condition, the first oxide film formed on the first surface remains unetched and most of the second oxide film formed on the second surface is etched. It is considered that this is mainly because the etching resistance of the first oxide film is high and the first oxide film is difficult to etch. That is, the main cause is considered to be that the etching rate of the first oxide film is lower than that of the second oxide film, that is, the etching resistance of the first oxide film is higher than that of the second oxide film.

After removing the second oxide film while leaving the first oxide film, the supply of the etching agent into the process chamber 201 is stopped. Then, a gaseous substance and the like remaining in the process chamber 201 are removed from the inside of the process chamber 201 according to the same processing procedures as the purging in step C.

The step B may be omitted in a case where the second oxide film formed on the second surface of the wafer 200 is, to some extent, thinner (e.g., extremely thinner) than the first oxide film, or in a case where a density of OH terminations on the surface of the second oxide film is, to some extent, lower (e.g., extremely lower) than a density of OH terminations on the surface of the first oxide film. In such cases, step D, which will be described below, is performed after step A is performed.

### (1.2.4) Step D

In step D, the wafer 200 after performing step B is exposed to a modifying agent to modify the surface of the first oxide film on the first surface so as to form an inhibitor layer on the surface of the first oxide film.

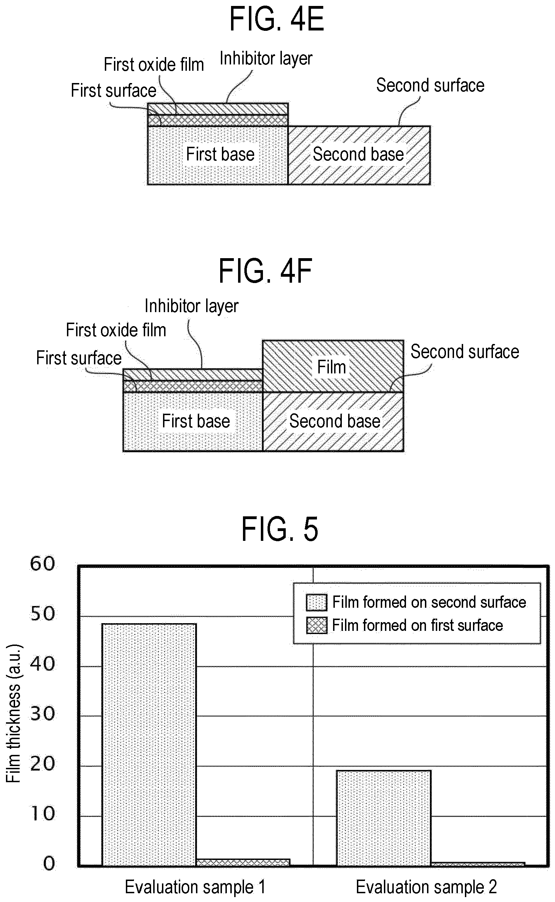

By performing step D, as shown in FIG. 4E, the inhibitor layer is formed on the surface of the first oxide film and on the surface of the first oxide film on the second surface.

Specifically, the valve 243d is opened to allow the modifying agent to flow through the gas supply pipe 232d. A flow rate of the modifying agent is regulated by the MFC 241d, and the modifying agent is supplied into the process chamber 201 via the gas supply pipe 232a and the nozzle 249a and is exhausted via the exhaust port 231a. In this operation, the modifying agent is supplied to the wafer 200 from the side of the wafer 200, such that the wafer 200 is exposed to the modifying agent. As the modifying agent, at least one selected from the group of silicon (Si)-containing gas and fluorine (F)-containing gas may be used. At this time, the valves 243e to 243g may be opened to allow an inert gas to be supplied into the process chamber 201 via the nozzles 249a to 249c, respectively.

Process conditions when supplying the Si-containing gas as the modifying agent in step D are exemplified as follows:
Processing temperature: room temperature (25 degrees C) to 500 degrees C, specifically room temperature to 250 degrees C
Processing pressure: 5 to 2,000 Pa, specifically 10 to 1,000 Pa
Processing time: 1 second to 120 minutes, specifically 30 seconds to 60 minutes
Supply flow rate of Si-containing gas: 0.001 to 3 slm, specifically 0.001 to 0.5 slm
Supply flow rate of inert gas (for each gas supply pipe): 0 to 20 slm.

Process conditions when supplying the F-containing gas as the modifying agent in step D are exemplified as follows:
Processing temperature: room temperature (25 degrees C) to 300 degrees C, specifically room temperature to 200 degrees C
Processing pressure: 1 to 2,000 Pa, specifically 1 to 1,000 Pa
Processing time: 1 second to 60 minutes
Supply flow rate of F-containing gas: 0.001 to 2 slm, specifically 0.001 to 0.5 slm
Supply flow rate of inert gas (for each gas supply pipe): 0 to 20 slm.

By exposing the wafer 200 to the modifying agent under the above-mentioned conditions, the inhibitor molecule, which is at least a portion of the molecular structure of the molecule constituting the modifying agent, are adsorbed on the surface of the first oxide film remaining on the first surface of the wafer 200, such that an inhibitor layer may be selectively formed on the surface of the first oxide film. This makes it possible to terminate the surface of the first oxide film on the first surface with the inhibitor molecule which is at least a portion of the molecular structure of the molecule constituting the modifying agent. The inhibitor layer functions to prevent adsorption of a precursor (a film-forming agent) on the first surface of the wafer 200 in step E to be described later, and inhibit formation of a film on the first surface. The inhibitor molecule is also referred to as a film-forming inhibition molecule (an adsorption inhibition molecule or a reaction inhibition molecule). The inhibitor layer is also referred to as a film-forming inhibition layer (an adsorption inhibition layer or a reaction inhibition layer).

In this step, at least a portion of the molecular structure of the molecule constituting the modifying agent may be adsorbed on a portion of the second surface but an amount of the adsorption is very small, and an amount of the adsorption on the surface of the first oxide film on the first surface is overwhelmingly large. Such selective (preferential) adsorption is possible because OH terminations serving as adsorption sites are formed over the entire region of the first surface, i.e., the first oxide film while OH terminations are not formed in many regions of the second surface.

In step D, as the modifying agent, a Si-containing gas may be supplied, a F-containing gas may be supplied, or both may be supplied. When both the Si-containing gas and the F-containing gas are supplied as the modifying agents, the Si-containing gas may be supplied first and then the F-containing gas may be supplied. After supplying the Si-containing gas, purging may be performed before supplying the F-containing gas. By supplying the Si-containing gas first, at least a portion of a molecular structure A of a molecule constituting the Si-containing gas may be adsorbed on the surface of the first oxide film. By supplying the F-containing gas after that, the F-containing gas may react with at least a portion of the molecular structure A adsorbed on the surface of the first oxide film, such that at least a portion of a molecular structure B of a molecule constituting the F-containing gas may be adsorbed on the surface of the first oxide film. In this way, by sequentially supplying the Si-containing gas and the F-containing gas as the modifying agents, it is possible to increase a density of the inhibitor layer, i.e., a density of the inhibitor molecule, as compared with a case where the F-containing gas is supplied alone as the modifying agent.

Examples of the Si-containing gas used as the modifying agent may include substances in which H and an amino group are bonded to Si, i.e., aminosilane-based gases, for example, a tetrakis(dimethylamino)silane (Si[N(CH₃)₂]₄) gas, a tris(dimethylamino)silane (Si[N(CH₃)₂]₃H) gas, a bis(diethylamino)silane (Si[N(C₂H₅)₂]₂H₂), a bis(tert-butylamino)silane (SiH₂[NH(C₄H₉)]₂), a (diisobutylamino)silane (SiH₃[N(C₄H₉)₂]) gas, a diisopropylamino)silane (SiH₃[N(C₃H₇)₂]), and the like. In addition, examples of the modifying agent may include substances in which an amino group and an alkyl group are bonded to Si, i.e., alkylaminosilane-based gases, for example, a (dimethylamino)trimethylsilane ((CH₃)₂NSi(CH₃)₃) gas, a (diethylamino)triethylsilane ((C₂H₅)₂NSi(C₂H₅)₃) gas, a (dimethylamino)triethylsilane ((CH₃)₂NSi(C₂H₅)₃) gas, a (diethylamino)trimethylsilane ((C₂H₅)₂NSi(CH₃)₃) gas, a (dipropylamino)trimethylsilane ((C₃H₇)₂NSi(CH₃)₃) gas, and the like. These can also be referred to as substances containing at least one selected from the group of H and an alkyl group, and an amino group. One or more of these may be used as the modifying agent.

Examples of the F-containing gas used as the modifying agent may include a ClF₃ gas, a ClF gas, a F₂ gas, F₂ + NO gas, ClF + NO gas, a NF₃ gas, a FNO gas, a tungsten hexafluoride (WF₆) gas, and the like. One or more of these may be used as the modifying agent.

After forming the inhibitor layer on the surface of the first oxide film on the first surface, the valve 243d is closed to stop the supply of the modifying agent into the process chamber 201. Then, a gaseous substance and the like remaining in the process chamber 201 are removed from the inside of the process chamber 201 according to the same processing procedures as the purging in step C.

### (1.2.5) Step E

In step E, the wafer 200 after performing step D is exposed to a film-forming agent to form a film on the second surface. In detail, in step E, steps E1 and E2 are performed sequentially.

By performing step E, as shown in FIG. 4F, a film is selectively formed on the second surface of the first surface and the second surface.

### (1.2.5.1) Step E1

In step E1, a precursor is supplied as a film-forming agent to the wafer 200 after the surface of the first oxide film on the first surface is selectively modified.

Specifically, the valve 243a is opened to allow the precursor to flow through the gas supply pipe 232a. A flow rate of the precursor is regulated by the MFC 241a, and the precursor is supplied into the process chamber 201 via the nozzle 249a and is exhausted via the exhaust port 231a. In this operation, the precursor is supplied to the wafer 200 from the side of the wafer 200, such that the wafer 200 is exposed to the precursor. At this time, the valves 243e to 243g may be opened to allow an inert gas to be supplied into the process chamber 201 via the nozzles 249a to 249c, respectively.

Process conditions when supplying the precursor as the film-forming agent in step E1 are exemplified as follows:
Processing temperature: room temperature (25 degrees C) to 700 degrees C, specifically 350 to 550 degrees C
Processing pressure: 1 to 2,000 Pa, specifically 1 to 1,333 Pa
Processing time: 1 to 180 seconds, specifically 10 to 120 seconds
Supply flow rate of precursor: 0.001 to 2 slm, specifically 0.01 to 1 slm
Supply flow rate of inert gas (for each gas supply pipe): 0 to 20 slm.

By supplying the precursor to the wafer 200 under the above-mentioned conditions, it is possible to cause at least a portion of the molecular structure of the molecule constituting the precursor to be selectively adsorbed on the second surface while suppressing adsorption of at least a portion of the molecular structure of the molecule constituting the precursor on the first surface. As a result, a first layer is selectively formed on the second surface. The first layer contains at least a portion of the molecular structure of the molecule constituting the precursor, which is a residue of the precursor. In other words, the first layer contains at least a portion of atoms constituting the precursor. In a case where a precursor to be described later is used, the first layer is, for example, a Si-containing layer.

In this step, at least a portion of the molecular structure of the molecule constituting the precursor may be adsorbed on a portion of the surface of the first oxide film on the first surface but an amount of the adsorption is very small, and an amount of the adsorption on the second surface is overwhelmingly large. Such selective (preferential) adsorption is possible because the inhibitor layer is formed over the entire region of the first surface, i.e., the first oxide film while the inhibitor layer is not formed in many regions of the second surface.

After the first layer is formed on the second surface, the valve 243a is closed to stop the supply of the precursor into the process chamber 201. Then, a gas and the like remaining in the process chamber 201 are removed from the inside of the process chamber 201 according to the same processing procedures as the purging in step C.

As the precursor, for example, a Si- and halogen-containing gas (Si- and halogen-containing substance) may be used. Halogen includes chlorine (Cl), fluorine (F), bromine (Br), iodine (I), and the like. The Si- and halogen-containing gas may contain halogen in the form of a chemical bond between Si and halogen. As the Si- and halogen-containing gas, for example, a silane-based gas containing a Si-Cl bond, a Si-F bond, a Si-Br bond, or a Si-I bond, that is, a chlorosilane-based gas, a fluorosilane-based gas, a bromosilane-based gas, or an iodosilane-based gas, may be used. The Si- and halogen-containing gas may further contain carbon (C), and in that case, C may be contained in the form of a Si-C bond. As the Si- and halogen-containing gas, for example, a silane-based gas containing Si, Cl, and an alkylene group and containing a Si-C bond, that is, an alkylenechlorosilane-based gas, may be used. The alkylene group includes a methylene group, an ethylene group, a propylene group, a butylene group, and the like. Further, as the Si- and halogen-containing gas, for example, a silane-based gas containing Si, Cl, and an alkyl group and containing a Si-C bond, that is, an alkylchlorosilane-based gas may be used. The alkyl group includes a methyl group, an ethyl group, a propyl group, a butyl group, and the like. The Si- and halogen-containing gas may further contain O, and in that case, O may be contained in the form of a Si-O bond, for example in the form of a siloxane bond (a Si-O-Si bond). As the Si- and halogen-containing gas, for example, a silane-based gas containing Si, Cl, and a siloxane bond, that is, a chlorosiloxane-based gas, may be used.

Examples of the precursor may include 1,1,3,3-tetrachloro-1,3-disilacyclobutane (C₂H₄Cl₄Si₂), 1,1,2,2-tetrachloro-1,2-dimethyldisilane ((CH₃)₂Si₂Cl₄), 1,2-dichloro-1,1,2,2-tetramethyldisilane ((CH₃)₄Si₂Cl₂), bis(trichlorosilyl)methane ((SiCl₃)₂CH₂), 1,2-bis(trichlorosilyl)ethane ((SiCl₃)₂C₂H₄), etc.. In addition, examples of the first precursor may include monochlorosilane (SiH₃Cl), dichlorosilane (SiH₂Cl₂), trichlorosilane (SiHCl₃), tetrachlorosilane (SiCl₄), hexachlorodisilane (Si₂Cl₆), octachlorotrisilane (Si₃Cl₈), etc. In addition, examples of the precursor may include hexachlorodisiloxane (Cl₃Si-O-SiCl₃), octachlorotrisiloxane (Cl₃Si-O-SiCl₂-O-SiCl₃), etc. In addition, examples of the precursor may include tetrafluorosilane (SiF₄), difluorosilane (SiH₂F₂), tetrabromosilane (SiBr₄), dibromosilane (SiH₂Br₂), tetraiodosilane (SiI₄), diiodosilane (SiH₂I₂), etc. One or more of these may be used as the precursor.

### (1.2.5.2) Step E2

In step E2, a reactant is supplied as a film-forming agent to the wafer 200 with the first layer formed on the second surface.

Specifically, the valve 243b is opened to allow the reactant to flow through the gas supply pipe 232b. A flow rate of the reactant is regulated by the MFC 241b, and the reactant is supplied into the process chamber 201 via the nozzle 249b and is exhausted via the exhaust port 231a. In this operation, the reactant is supplied to the wafer 200 from the side of the wafer 200, such that the wafer 200 is exposed to the reactant. At this time, the valves 243e to 243g may be opened to allow an inert gas to be supplied into the process chamber 201 via the nozzles 249a to 249c, respectively.

Process conditions when supplying the reactant as the film-forming agent in step E2 are exemplified as follows:
Processing temperature: room temperature (25 degrees C) to 700 degrees C, specifically 350 to 550 degrees C
Processing pressure: 1 to 4,000 Pa, specifically 1 to 1,333 Pa
Processing time: 1 to 180 seconds, specifically 10 to 120 seconds
Supply flow rate of reactant: 0.01 to 20 slm, specifically 0.01 to 10 slm
Supply flow rate of inert gas (for each gas supply pipe): 0 to 20 slm.

By supplying the reactant to the wafer 200 under the above-mentioned conditions, at least a portion of the first layer formed on the second surface may be reacted with the reactant to change the first layer into a second layer. In a case where the reactant includes, for example, a N-containing gas (a N-containing substance), at least a portion of the first layer formed on the second surface may be nitrided to form a layer containing Si and N, i.e., a silicon nitride layer (SiN layer), on the second surface. At this time, the surface of the first oxide film on the first surface is maintained by suppressing nitridation due to action of the inhibitor layer or the like.

After the second layer is formed on the second surface, the valve 243b is closed to stop the supply of the reactant into the process chamber 201. Then, a gas and the like remaining in the process chamber 201 are removed from the inside of the process chamber 201 according to the same processing procedures as the purging in step C.

As the reactant, for example, a N-containing gas (a N-containing substance) may be used. As the N-containing gas (a N-containing substance), for example, a N- and H-containing gas or a C- and N-containing gas may be used. As the N- and H-containing gas, for example, a hydrogen nitride-based gas containing a N-H bond may be used. As the C- and N-containing gas, an amine-based gas or an organic hydrazine-based gas may be used.

As the reactant, for example, ammonia (NH₃), hydrazine (N₂H₄), diazene (N₂H₂), N₃H₈, etc. may be used. In addition, examples of the reactant may include monoethylamine (C₂H₅NH₂), diethylamine ((C₂H₅)₂NH), triethylamine ((C₂H₅)₃N), monomethylamine (CH₃NH₂), dimethylamine ((CH₃)₂NH), trimethylamine ((CH₃)₃N), etc. In addition, as the reactant, monomethylhydrazine ((CH₃)HN₂H₂), dimethylhydrazine ((CH₃)₂N₂H₂), trimethylhydrazine ((CH₃)₂N₂(CH₃)H), etc. may be used. One or more of these may be used as the reactant.

### [Performing Predetermined Number of Times]

By performing a cycle a predetermined number of times (n times, where n is an integer of 1 or 2 or more), the cycle including the above-described steps E1 and E2, for example, the cycle including alternately (non-simultaneously) performing steps E1 and E2, a film may be selectively formed on the second surface among the first surface and the second surface of the wafer 200, as shown in FIG. 4F. As described above, in a case where the reactant includes, for example, a N-containing gas, a silicon nitride film (SiN film) is formed on the second surface. The above-described cycle may be performed a plurality of times. That is, a thickness of the second layer formed per cycle may be made to be smaller than a desired film thickness, and the above-described cycle may be performed a plurality of times until a thickness of a film formed by stacking second layers reaches the desired film thickness.

When steps E1 and E2 are performed, the inhibitor layer present on the surface of the first oxide film is maintained on the surface of the first oxide film, and therefore may suppress the growth of the film on the surface of the first oxide film. However, in a case where the formation of the inhibitor layer on the surface of the first oxide film is insufficient due to some factors, formation and growth of the film on the surface of the first oxide film may occur very slightly. However, even in this case, the thickness of the film formed on the surface of the first oxide film is much thinner than the thickness of the film formed on the second surface. In the present disclosure, the expression "selectively (preferentially) forming a film on the second surface" includes a case where no film is formed on the surface of the first oxide film on the first surface and a film is formed on the second surface, and a case where a very thin film is formed on the surface of the first oxide film and a much thicker film is formed on the second surface.

In step E, the thickness of the film formed on the second surface may be made to be, for example, 0.5 nm to 10 nm, specifically 1 nm to 5 nm, and more specifically 1.5 nm to 3 nm.

In step E, a Si-containing film other than the SiN film may be formed. Examples of the Si-containing film may include a silicon film (a Si film), a silicon carbonitride film (a SiCN film), a silicon boronitride film (a SiBN film), a silicon boroncarbonitride film (a SiBCN film), a silicon oxycarbonitride film (a SiOCN film), a silicon oxycarbide film (a SiOC film), a silicon oxynitride film (a SiON film), a silicon oxide film (a SiO film), etc. In addition to the Si-containing film, a metal-containing film may be formed in step E. Examples of the metal-containing film may include an aluminum film (an Al film), a titanium film (a Ti film), a hafnium film (a Hf film), a zirconium film (a Zr film), a tantalum film (a Ta film), a tungsten film (a W film), a molybdenum film (a Mo film), a ruthenium film (a Ru film), an aluminum nitride film (an AlN film), a titanium nitride film (a TiN film), a hafnium nitride film (a HfN film), a zirconium nitride film (a ZrN film), a tantalum nitride film (a TaN film), a tungsten nitride film (a WN film), a molybdenum nitride film (MoN film), an aluminum oxide film (an AlO film), a titanium oxide film (a TiO film), a hafnium oxide film (a HfO film), a zirconium oxide film (a ZrO film), a tantalum oxide film (a TaO film), a tungsten oxide film (a WO film), a molybdenum oxide film (a MoO film), a ruthenium oxide film (RuO film), etc.

### (After-Purge and Returning to Atmospheric Pressure)

After the formation of the film on the second surface of the wafer 200 is completed, an inert gas acting as a purge gas is supplied into the process chamber 201 from each of the nozzles 249a to 249c and is exhausted via the exhaust port 231a. Thus, the inside of the process chamber 201 is purged and a gas or reaction by-products remaining in the process chamber 201 are removed from the inside of the process chamber 201 (after-purge). Thereafter, the internal atmosphere of the process chamber 201 is substituted with an inert gas (inert gas substitution) and the internal pressure of the process chamber 201 is returned to a normal pressure (returning to atmospheric pressure).

### (Boat Unloading and Wafer Discharging)

Thereafter, the seal cap 219 is moved down by the boat elevator 115 to open the lower end of the manifold 209. Then, the processed wafers 200 supported by the boat 217 are unloaded from the lower end of the manifold 209 to the outside of the reaction tube 203 (boat unloading). After the boat unloading, the shutter 219s is moved and the lower end opening of the manifold 209 is sealed by the shutter 219s via the O-ring 220c (shutter closing). The processed wafers 200 are unloaded from the reaction tube 203 and are then discharged from the boat 217 (wafer discharging).

### (1.3) Effects of the First Embodiment

According to the first embodiment, one or more effects set forth below may be achieved.

In the processing method according to the first embodiment, by performing steps A and B, a state in which the first oxide film is formed on the first surface and the second surface is exposed may be made efficiently, effectively, and accurately. In addition, the adsorption sites on the surface of the first oxide film formed on the first surface may be adjusted and optimized by the secondary action of the etching agent. As a result, it is possible to effectively perform a selective formation of the inhibitor layer on the surface of the first oxide film formed on the first surface and to effectively perform a selective formation of the film on the second surface. That is, it is possible to effectively perform selective processing on a desired surface.

In the processing method according to the first embodiment, when the first oxide film and the second oxide film are formed on the first surface and the second surface, respectively, the composition of the first oxide film and the composition of the second oxide film may be made different. This makes it possible to make the etching resistance of the first oxide film different from the etching resistance of the second oxide film and to make the etching resistance of the first oxide film higher than the etching resistance of the second oxide film. As a result, when the wafer 200 is exposed to the etching agent, it is possible to effectively remove the second oxide film while leaving the first oxide film.

In the processing method according to the first embodiment, when the wafer 200 is exposed to the etching agent it is possible to effectively remove the second oxide film with high accuracy by etching while leaving the first oxide film.

In the processing method according to the first embodiment, it is possible to effectively make the etching resistance of the first oxide film higher than the etching resistance of the second oxide film.

In the processing method according to the first embodiment, the native oxide film formed unevenly on the first surface and the second surface under no control is removed, thereby making it possible to improve uniformity of the film thicknesses of the first oxide film and the second oxide film formed on the first surface and the second surface, respectively. In addition, by making the etching resistances of the first oxide film and the second oxide film formed on the first surface and the second surface exposed by removing the native oxide film, respectively, be different from each other, it is possible to effectively make the etching resistance of the first oxide film higher than that of the second oxide film.

In the processing method according to the first embodiment, when the second oxide film formed on the second surface is removed by etching, it is possible to effectively adjust and optimize the adsorption sites on the surface of the first oxide film formed on the first surface by the secondary action of the etching agent.

In the processing method according to the first embodiment, it is possible to improve a controllability of each of the process by using the etching agent in step B and the process by using the etching agent in step C. In addition, in a case where the etching agent used in step B includes a HF aqueous solution (hydrogen fluoride aqueous solution), when the second oxide film formed on the second surface is removed by etching, it is possible to more effectively adjust and optimize the adsorption sites on the surface of the first oxide film formed on the first surface by the secondary action of the etching agent.

In the processing method according to the first embodiment, it is possible to effectively perform a selective film formation on the second surface. In other words, it is possible to effectively improve a selectivity in the selective film formation.

### (2) Other Embodiments

The processing sequence of the first embodiment may be modified as in the other embodiments described below. These embodiments may be combined in any manner. Unless otherwise specified, processing procedures and process conditions in each step of each embodiment may be the same as the processing procedures and process conditions in each step of the above-described processing sequence.

### (2.1) Second Embodiment

In the processing sequence of the first embodiment, an example in which the first surface includes the Si film and the second surface includes the SiN film is described, but the present disclosure is not limited thereto. The present disclosure may also be applied to a case in which the first surface contains a semiconductor substance other than the Si film and the second surface contains a nitride other than the SiN film. The present disclosure may also be applied to a case in which the first surface contains a semiconductor substance other than the Si film and the second surface contains a substance containing a semiconductor element and nitrogen other than the SiN film. The first surface may be made of a substance that is more easily oxidized than the second surface, that is, the first surface may be made of a substance that is less resistant to oxidation than the second surface. For example, the first surface may be made of a substance that is higher in Si atomic concentration and/or is lower in N atomic concentration than the second surface. In addition, the first surface and the second surface may be made of a substance that makes the etching rate of the first oxide film formed by oxidizing the first surface lower than the etching rate of the second oxide film formed by oxidizing the second surface. That is, the first surface and the second surface may be made of a substance that makes the etching resistance of the first oxide film formed by oxidizing the first surface higher than the etching resistance of the second oxide film formed by oxidizing the second surface. The first surface and the second surface may be made of a substance that satisfies these relationships, and the first surface and the second surface may be made of, in addition to the Si film and the SiN film, for example, at least one selected from the group of a silicon-containing film such as a single crystal Si (a Si wafer), a SiCN film, a SiBN film, a SiBCN film, a SiOCN film, a SiOC film, or a SiON film, and a metal-containing film such as an Al film, a Ti film, a Hf film, a Zr film, a Ta film, a W film, a Mo film, a Ru film, an AlN film, a TiN film, a HfN film, a ZrN film, a TaN film, a WN film, or a MoN film. The second embodiment may also obtain the same effects as the first embodiment.

### (2.2) Third Embodiment

In the processing sequence of the first embodiment, an example in which steps C, A, B, D, and E are performed sequentially is described, but the present disclosure is not limited thereto.

For example, in a case where the native oxide film formed on the first surface and the second surface of the wafer 200 is removed in advance and the wafer 200 maintained in such a state is used, step C may be omitted. In that case, steps A, B, D, and E are performed sequentially.

In addition, for example, in a case where the second oxide film formed on the second surface of the wafer 200 is, to some extent, thinner (e.g., extremely thinner) than the first oxide film or in a case where a density of OH terminations on the surface of the second oxide film is, to some extent, lower (e.g., extremely lower) than a density of OH terminations on the surface of the first oxide film, step B may be omitted. In that case, steps C, A, D, and E are performed sequentially. In that case, when step C may be omitted, steps A, D, and E are performed sequentially. In these cases, in step D, the inhibitor layer is formed on the surface of the first oxide film and the surface of the second oxide film, and a density of the inhibitor layer formed on the surface of the second oxide film is lower than that of the inhibitor layer formed on the surface of the first oxide film. As a result, in step E, by performing a cycle a predetermined number of times, the cycle including steps E1 and E2, the inhibitor layer formed on the surface of the second oxide film is removed and/or invalidated by the action of the film-forming agent (a precursor or a reactant), and then a film is formed on the surface of the second oxide film starting from that portion.

These cases may also obtain the same effects as the first embodiment.

### (2.3) Fourth Embodiment

In addition, in the first embodiment, an example in which the above-described processing sequence is performed in the same process chamber of the same processing apparatus (in-situ) is described. The present disclosure is not limited to the first embodiment. For example, any step and any other step of the above-described processing sequence may be performed in different process chambers of different processing apparatuses (ex-situ), or may be performed in different process chambers of the same processing apparatus. These cases may also obtain the same effects as the first embodiment.

In the above-described various cases, in a case where a series of steps are performed in-situ, the wafer 200 is not exposed to the atmosphere during the process, the wafer 200 may be consistently processed while being placed under vacuum, and stable processing may be performed. In addition, in a case where some steps are performed ex-situ, the internal temperature of each process chamber may be set in advance to, for example, the processing temperature in each step or a temperature close to the processing temperature, a time for temperature regulation may be shortened, and a throughput, i.e., a productivity, may be improved.

Recipes used in each process may be provided individually according to the processing contents and may be recorded and stored in the memory 121c via a telecommunication line or the external memory 123. Moreover, at the beginning of each process, the CPU 121a may properly select an appropriate recipe from the recipes recorded and stored in the memory 121c according to the processing contents. Thus, it is possible to form films of various kinds, composition ratios, qualities, and thicknesses with enhanced reproducibility in the processing apparatus. Further, it is possible to reduce an operator's burden and to quickly start each process while avoiding an operation error.

The recipes mentioned above are not limited to newly-provided ones but may be provided, for example, by modifying existing recipes that are already installed in the processing apparatus. Once the recipes are modified, the modified recipes may be installed in the processing apparatus via a telecommunication line or a recording medium storing the recipes. In addition, the existing recipes already installed in the existing processing apparatus may be directly modified by operating the input/output device 122 of the processing apparatus.

An example in which a film is formed by using a batch-type processing apparatus configured to process a plurality of wafers 200 at a time is described in the first embodiment. The present disclosure is not limited to the first embodiment, but may be applied, for example, to a case where a film is formed by using a single-wafer type processing apparatus configured to process a single wafer 200 or several wafers 200 at a time. In addition, an example in which a film is formed by using a processing apparatus provided with a hot-wall-type process furnace is described in the first embodiment. The present disclosure is not limited to the first embodiment, but may be applied to a case where a film is formed by using a processing apparatus provided with a cold-wall-type process furnace.

Even in the case of using these processing apparatuses, each process may be performed according to processing procedures and process conditions which are the same as those in the first to third embodiments, and effects which are the same as those of the first to third embodiments may be obtained.

The first to fourth embodiments may be used in proper combination. Processing procedures and process conditions used in this case may be the same as, for example, the processing procedures and the process conditions in the first to fourth embodiments.

### [Examples]

The present disclosure will be described in more detail below based on Examples, but the present disclosure is not limited to these Examples.

### <First Example>

An evaluation sample 1 of a first example is produced by performing a processing sequence which is the same as that of the first embodiment on a wafer including ta first surface and a second surface which are the same as those of the first embodiment to form a film on the second surface. The process conditions in each step when producing the evaluation sample 1 are made to be predetermined conditions within a range of the process conditions in each step of the first embodiment. In the first example, the first surface is a surface of a Si film, the second surface is a surface of a SiN film, and the film formed on the second surface is a SiN film.

### <First Reference Example>

An evaluation sample 2 of the first reference example is produced by performing a processing sequence in which step B of the processing sequence in the first example is omitted, on a wafer including a first surface and a second surface which are the same as those of the first embodiment to form a film on the second surface. Process conditions in each step when producing the evaluation sample 2 are made to be the same as the process conditions in each step except for step B in the above-described first example. In the first reference example, similar to the first example, the first surface is a surface of a Si film, the second surface is a surface of a SiN film, and the film formed on the second surface is a SiN film.

A thickness of the film formed on the first surface and a thickness of the film formed on the second surface are respectively measured for each evaluation sample produced. The results are shown in FIG. 5. In FIG. 5, a horizontal axis represents a type of evaluation sample, and a vertical axis represents a thickness of the film (arbitrary unit: a.u.). A bar graph on the left side of each evaluation sample indicates the thickness of the film formed on the second surface, and a bar graph on the right side of each evaluation sample indicates the thickness of the film formed on the first surface.

From FIG. 5, it may be seen that in both the evaluation sample 1 and the evaluation sample 2, the film formed on the second surface is thicker than the film formed on the first surface, and a film is selectively formed on the second surface. In addition, it may be seen that a difference in film thickness between the film formed on the first surface and the film formed on the second surface is larger, being 2.5 times or more, in the evaluation sample 1 than in the evaluation sample 2, and the selectivity in evaluation sample 1 is much higher. From these, it is confirmed that both the first example and the first reference example may selectively form a film, and the first example may obtain a much higher selectivity than the first reference example.

According to the present disclosure in some embodiments, it is possible to effectively perform a selective process on a desired surface.

While certain embodiments are described above, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A processing method comprising:
(a) providing a substrate including a first surface and a second surface whose material is different from a material of the first surface, a first oxide film being formed on the first surface, and a second oxide film being formed on the second surface; and
(b) removing the second oxide film formed on the second surface while leaving the first oxide film formed on the first surface by exposing the substrate to an etching agent.

2. The processing method of Claim 1, wherein the first surface contains a semiconductor substance and the second surface contains a nitride.

3. The processing method of Claim 1, wherein the first oxide film and the second oxide film are formed by oxidation of the first surface and the second surface by exposing the substrate to an oxidizing agent.

4. The processing method of Claim 1, wherein the first oxide film contains a semiconductor element, and a composition of the first oxide film is richer in the semiconductor element than a stoichiometric composition.

5. The processing method of any one of Claims 1 to 4, further comprising (c) removing a native oxide film formed on the first surface and the second surface by exposing the substrate before performing (a) to an etching agent.

6. The processing method of Claim 5, wherein an exposure time of the substrate to the etching agent in (b) is made to be different from an exposure time of the substrate to the etching agent in (c).

7. The processing method of Claim 5, wherein the etching agent used in (b) and the etching agent used in (c) contain a same substance, and
wherein a concentration of the substance in the etching agent used in (b) is made to be different from a concentration of the substance in the etching agent used in (c).

8. The processing method of Claim 7, wherein the substance contains HF.

9. The processing method of Claim 5, wherein the etching agent used in (b) includes a HF aqueous solution or a HF gas, and
wherein the etching agent used in (c) includes a HF aqueous solution or a HF gas.

10. The processing method of any one of Claims 1 to 4, wherein the etching agent used in (b) contains HF and H₂O.

11. The processing method of any one of Claims 1 to 4, further comprising (d) modifying a surface of the first oxide film on the first surface by exposing the substrate after performing (b) to a modifying agent so as to form an inhibitor layer on the surface of the first oxide film.

12. The processing method of Claim 11, further comprising (e) forming a film on the second surface by exposing the substrate after performing (d) to a film-forming agent.

13. A method of manufacturing a semiconductor device, comprising:
(a) providing a substrate including a first surface and a second surface whose material is different from a material of the first surface, a first oxide film being formed on the first surface, and a second oxide film being formed on the second surface; and
(b) removing the second oxide film formed on the second surface while leaving the first oxide film formed on the first surface by exposing the substrate to an etching agent.

14. A processing apparatus comprising:
a provider configured to provide a substrate;
an etching agent exposure system configured to expose the substrate to an etching agent; and
a controller configured to be capable of controlling the provider and the etching agent exposure system so as to perform a process including:
(a) providing a substrate including a first surface and a second surface whose material is different from a material of the first surface, a first oxide film being formed on the first surface, and a second oxide film being formed on the second surface; and
(b) removing the second oxide film formed on the second surface while leaving the first oxide film formed on the first surface by exposing the substrate to the etching agent.

15. A program that causes, by a computer, a processing apparatus to perform a process comprising:
(a) providing a substrate including a first surface and a second surface whose material is different from a material of the first surface, a first oxide film being formed on the first surface, and a second oxide film being formed on the second surface; and
(b) removing the second oxide film formed on the second surface while leaving the first oxide film formed on the first surface by exposing the substrate to an etching agent.
